(19)

Europäisches
Patentamt
European
Patent Office
Office européen
des brevets

(11) **EP 1 936 813 A1**

(12) **EUROPEAN PATENT APPLICATION**

(43) Date of publication:
**25.06.2008 Bulletin 2008/26**

(51) Int Cl.:
***H03M 13/45*** *(2006.01)*

(21) Application number: **06126462.8**

(22) Date of filing: **19.12.2006**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK RS** | (72) Inventor: **Kravtchenko, Alexander**<br>**78056 Villingen-Schwenningen (DE)**<br><br>(74) Representative: **Schmidt-Uhlig, Thomas**<br>**Deutsche Thomson OHG**<br>**European Patent Operations**<br>**Karl-Wiechert-Allee 74**<br>**30625 Hannover (DE)** |
| (71) Applicant: **Deutsche Thomson OHG**<br>**30625 Hannover (DE)** | |

(54) **Method and apparatus for reducing miscorrection in an extended Chase decoder**

(57)      In an extended Chase decoder miscorrections are reduced by a method where for each received word (r) a binary multiplex control signal (UE) is derived, according to which either a hard demodulated word (526) or a Chase decoded codeword (527) is used as the output. Derivation of the multiplex control signal (UE) involves distances of the received word (r) to closest (d) and second closest (s) codewords, as well as averages (dec_mean, com_mean) and differences (DIFF M, dif_ metric) thereof.

EP 1 936 813 A1

**Description**

Field of the invention

The present invention relates to digital communication and data storage systems and more specifically to decoding of error correction coded data.

Background of the invention

Chase decoding, as described for example in G. C. Clark, Jr., and J. B. Cain, "Error-Correction Coding For Digital Communications", Plenum Press, N.Y.,pp. 176-172, is used widely in digital communication systems, as known from US5559506, US6134694, US6065147, or US2004/0247238. Soft-decision decoding is implemented in Chase decoder. Soft-decision decoding provides better error performance than hard-decision decoding. In general, soft-decision maximum likelihood decoding of a code has about 3 db of gain over algebraic decoding. But investigation of Chase decoder showed a high probability of miscorrected code words at low SNR that restricts its use in some applications. For example the application of Chase decoder in optical data storage system demands absence of miscorrection in decoded code words, because a miscorrection in CD Audio readout causes an audible "click", and in DVD readout it may cause a "macroblock".

A miscorrection is characterized by the fact that, during transmission or storage, a code word has suffered a combination of errors such that the received or read word is corrected into a wrong code word at the decoder. This kind of mis-correction happens when the error is stronger than what can be corrected and the error pattern mimics another code word, in the sense of falling within that codeword's span of correctability.

A decoder implementing a specific form of Chase decoding has been proposed in US5010554. There, a receiver converts the received symbols into hard bits representing the received data and soft bits representing reliability values; and the least reliable symbol is identified. The syndrome is calculated from the hard detected bits. In response to each non-zero syndrome, several error pattern candidates, each identifying a combination of one or more symbols that, if corrected, would produce a valid code word, are retrieved. The reliability metrics of the implicated symbols are evaluated for each retrieved error pattern candidate, and the implicated symbols of one candidate are corrected to produce the valid code word closest to the received symbol values. The validity of code words is checked with syndrome generator, if the syndrome set is zero then the decoding process is assumed to be correct. This can be seen as a disadvantage, because at low signal to noise rate (SNR), zero syndrome sets are generated with high probability for miscorrected code words.

The invention relates to a concatenated error correction scheme, having an outer encoder, a scrambler and an inner encoder on the transmitter/storage write side and having the corresponding inner decoder, descrambler, and outer decoder on the receive or storage read side. In such a scheme, if the inner decoder erroneously generates miscorrections, these nominally constitute valid codewords and are signalled to the subsequent outer decoder as correct data.

Invention

The problem to be addressed by the present invention is to avoid the aforementioned disadvantages. In the invention it has been recognised that, in cases where there is a high probability of mis-correction, not inner correcting the received vectors and signalling them as erroneous is preferable over correcting them.

The latter is likely to imply a miscorrection, which then confuses or deteriorates the performance of the subsequent outer decoder, because the indication that the miscorrected words were correct actually is in error.

Let C be a binary, (n,k), linear code with Hamming distance dmin(C) that is used in a Chase decoder. As widely used, the notion of (n,k) indicates that codewords in C consist of n symbols, k of which are payload symbols, with k<n. Transmission over an Additive White Gaussian Noise AWGN channel is assumed. Let $v = (v0, ..., vi, ... ,vn-1)$ be a code word in C, with $vi$ from $\{0,1\}$. For transmission purposes we assume that this codeword is represented by a bipolar word $c = (c0, ..., ci, ..., cn-1)$, where $ci = 2*vi-1$ for $0<=i<n$. Let $c_1 = (c_{1,0}, ..., c_{1,i}, ... , c_{1,n-1})$ and $c_2 = (c_{2,0}, ... , c_{2,i}, ..., c_{2,n-1})$ be two bipolar words corresponding to codewords $v_1 = (v_{1,0}, ... , v_{1,n-1})$ and $v_2 = (v_{2,0}, ..., v_{2,n-1})$ respectively. The squared Euclidean distance between $c_1$ and $c_2$ is then defined as

$$EUC\_D = \left| c_1 - c_2 \right|^2 = \sum_{i=0}^{n-1} (c_{1,i} - c_{2,i})^2 \qquad (1)$$

Let r = ($r_0$, ..., $r_{n-1}$) be a symbol sequence or word as received via an AWGN channel:

$$r = e + g, \qquad\qquad (2)$$

where e = ($e_0$, ..., $e_{n-1}$) is the transmitted signal sequence associated with v, and g = (go, ... , $g_{n-1}$) corresponds to a sequence of Gaussian noise samples.

According to the Chase decoding algorithm, for every received symbol sequence r, a primary code word d= ($d_0$, ..., $d_{n-1}$) is determined by:

$$d = c_m \text{ if } |r-c_m|^2 \ <= \ |r-c_j|^2 , \ m \neq j \qquad\qquad (3)$$

where j=1,...,$2^L$, L is the number of least reliable positions in r, and the codewords $c_j$ result from algebraic decoding the received word r after it has been modified in all possible ways in its L least reliable symbol positions. This specific form of Chase decoding is known as "Algorithm 2" or "Chase 2". With other words, the primary code word d for a given received sequence or word r is that one from amongst a subset {$C_j$} of all codewords, which has the smallest distance from r; in the following we call that distance the primary distance EUC_DP.

Further, we denote as s=($s_0$, ..., $s_{n-1}$) or as a neighboring or competing code word of r, that codeword from the subset {$c_j$}, which has the second smallest distance from r, this distance being called the competing distance EUC_DC

$$EUC\_DC = |r-s|^2 \qquad\qquad (4)$$

By this definition, EUC_DP < EUC_DC.

The general idea of the invention is to measure an average primary distance and an average competing distance, to calculate the difference between the average primary distance and the average competing distance, to use this difference as a quality indicator which is monotonously related to the Bit Error Rate BER, and, depending on and adaptive to the quality indicator, to restrict the error correction action of the Chase decoder, in order to avoid miscorrections.

The mentioned problems are addressed, according to the invention, by a method for reducing miscorrection in an extended Chase decoder which receives a received symbol sequence comprising reliability information and groups it into received words. Specifically, then, a binary output multiplex control signal is being derived from the received words, one value of the output multiplex control signal being associated to each of output words of the extended Chase decoder. Concurrently, from each of the received words, a hard demodulated word and a Chase decoded codeword is derived. As the output word of the extended Chase decoder, the hard demodulated word is used in case the associated output multiplex control signal exhibits a first value indicating an erasure, and the Chase decoded codeword is used in case the output multiplex control signal exhibits the other value indicating a valid codeword.

Advantageously, deriving the output multiplex control signal comprises determining, from each received word, a set of candidate codewords by algebraic decoding of the received word modified in all possible ways in its L least reliable symbol positions, selecting, as a primary codeword, that codeword among the set of candidate codewords, that is closest to the received word, selecting, as a competing codeword, that codeword among the set of candidate codewords, that is second closest to the received word, calculating a primary distance and a competing distance between the received word and the primary codeword / competing codeword, respectively, and setting the output multiplex control signal to the first value in case a distance difference between the competing distance and the primary distance is smaller than a threshold, and to the other value in case the distance difference is greater than or equal to the threshold. This has the advantage of exploiting the closeness or proximity information contained in the soft information of the received vector compared to the codewords of the used code.

Advantageously, the threshold used in the above comparison is derived from the difference between an average primary distance and an average competing distance that are calculated by temporally low pass filtering the sequences of primary distances and competing distances, respectively. This has the advantage of using a measure which represents an estimate of the channel bit error rate, while being based solely on properties of the received signal.

Advantageously, the output words of the extended Chase decoder and the associated output multiplex control signals are forwarded to a subsequent stage of a descrambler or outer error correction decoder. In that subsequent stage then, those of the output words where the associated output multiplex control signal exhibits the first value, are interpreted as erasures, and those of the output words where the associated output multiplex control signal exhibits the other value are interpreted as error free or valid codewords. This has the advantage of providing to a subsequent outer error correction stage an erasure information that is not deteriorated by miscorrections.

Drawings

Exemplary embodiments of the invention are illustrated in the drawings and are explained in more detail in the following description.

In the figures,

Fig. 1    shows the average primary distance and average competing distance as a function of SNR.
Fig. 2    shows the difference between average primary and competing distance over SNR.
Fig. 3    shows miscorrection statistics from simulations.
Fig. 4    shows bit error rates BER for known Chase decoders and for modified Chase decoders according to the invention.
Fig. 5    shows the block diagram of a Chase decoder modified according to this invention.
Fig. 6    illustrates a decoding method according to this invention.

Exemplary embodiments

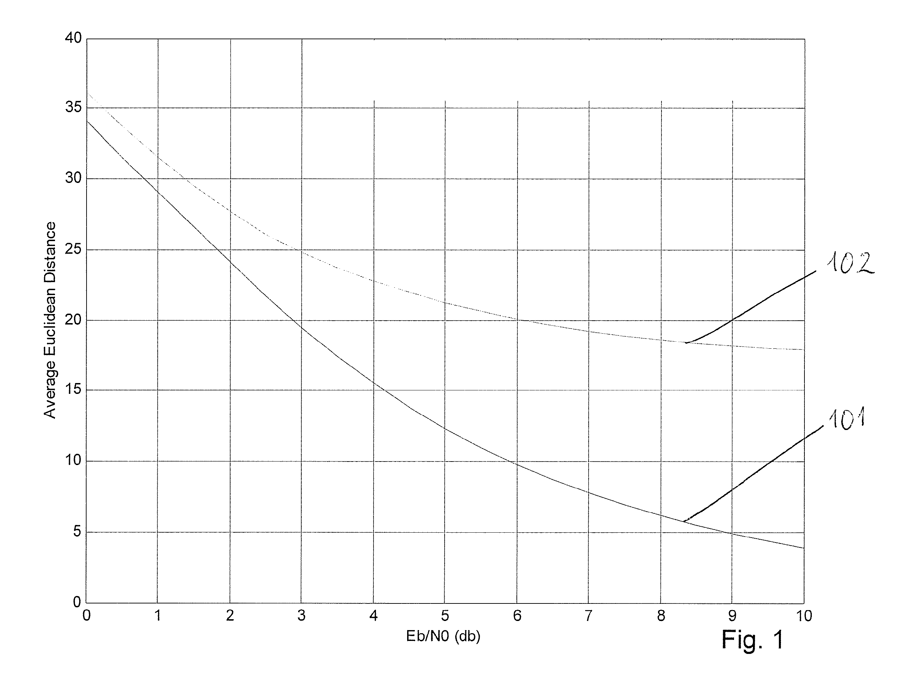

Fig. 1 shows the graph of the average primary distance 101 and of the average competing distance 102, both as a function of Eb/N0 or SNR, in a range of 0 to 10 dB. Both curves monotonously decrease with increasing SNR, whereas their vertical distance increases.

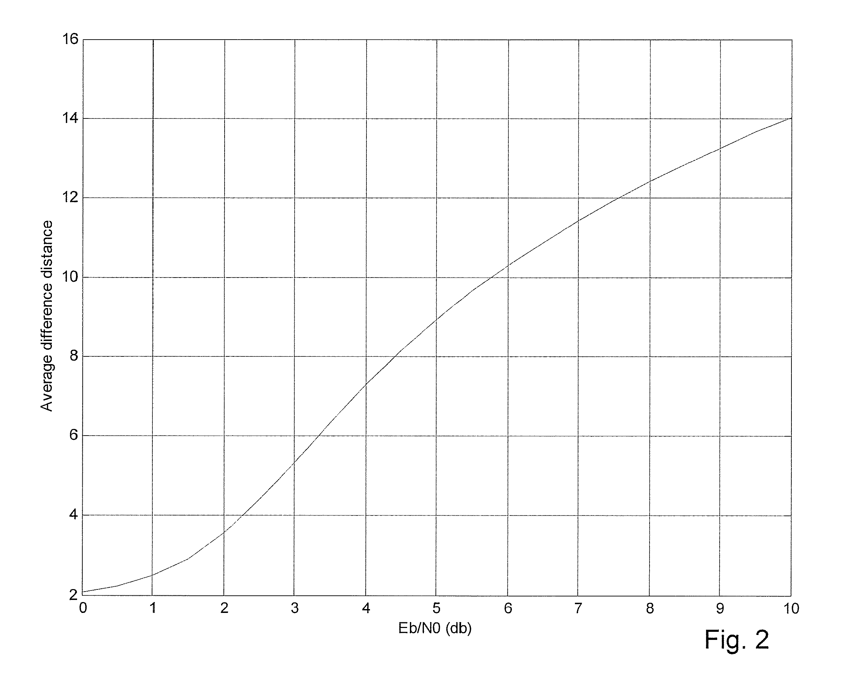

Fig. 2 shows the graph of the difference between the curves of Fig. 1, also as a function of Eb/N0 or SNR in a range of 0 to 10 dB. This function has its minimum at 0 dB of SNR and increases monotonously with increasing SNR. Because of this property, the difference between average primary distance and average candidate distance, which can be calculated on the decoder side, can be used as an indirect indication or estimate of the input bit error rate BER of the channel, which of course can not directly be measured at the decoder side.

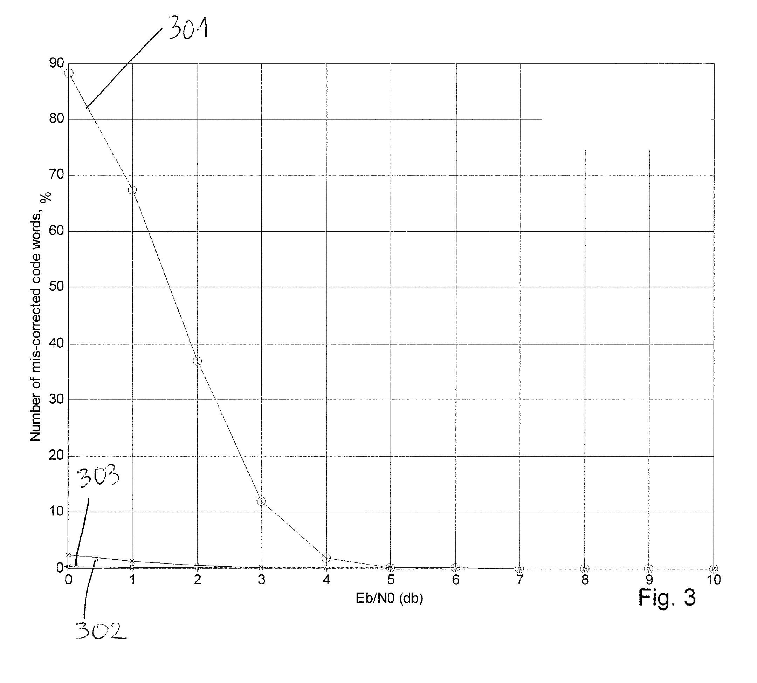

Fig. 3 shows miscorrection statistics from simulations. Curve 301 shows the percentage of miscorrected codewords for the known Chase decoding algorithm. The simulations have been run for the example of a BCH (63,51,3) code. The percentage of miscorrection is biggest at 0 dB of SNR, i.e. when the input BER is highest, and decreases monotonously. Beyond 5dB, the Chase decoder practically does not generate any miscorrections any more. But below, i.e. in the range of 0 to 5 dB of SNR, a probability of miscorrection exists, so that the error correction performance of the Chase decoder can be considered as limited in this region.

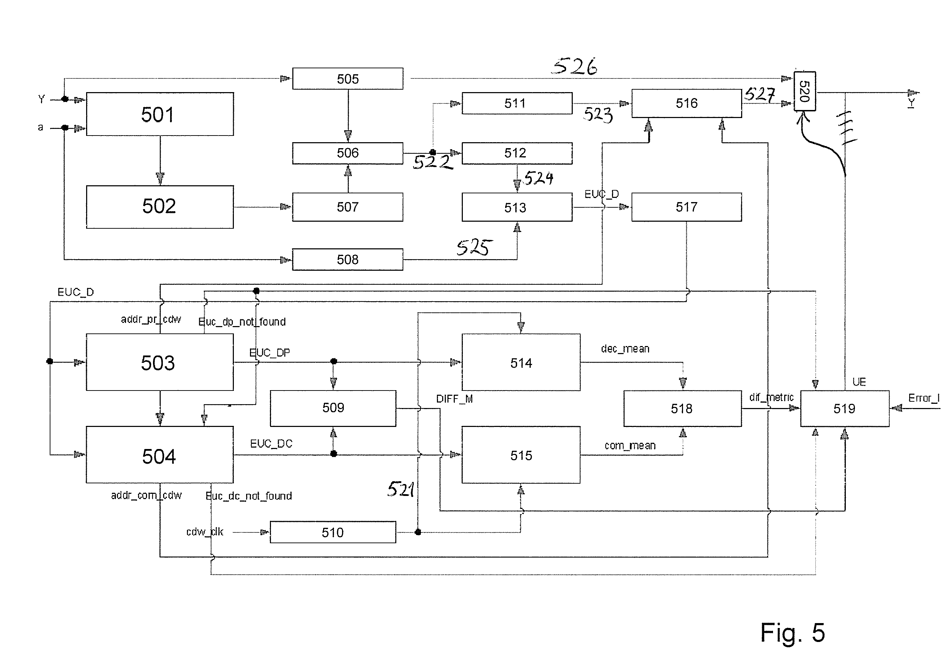

Fig. 5 shows the block diagram of a Chase decoder modified according to this invention. A Reliability Metric Generator 501 receives demodulated data Y and channel measurements a, and identifies the locations of a number L of the least reliable symbols within the input symbols of a received sequence Y. L=4 is used in the embodiment. A Memory 502 stores the positions of the L least reliable symbols as identified by the Reliability Metric Generator 501. A First Minimum Value Searcher 503 reads 16 possible Euclidean Distance values EUC_D from a Euclidean Distance memory 517 and determines and outputs the Minimum Distance corresponding to the primary distance EUC DP. The First Minimum Value Searcher 503 also generates the Address addr_pr_cdw of the Primary Codeword and forwards it to a Corrected Test Pattern Memory 516.

A Second Minimum Value Searcher 504 searches, in the Euclidean Distance Memory 517, for the Euclidean Distance for the competing code word as defined above. In the Second Minimum Value Searcher 504, the Euclidean Distance values EUC_D from the Euclidean Distance Memory 517 are compared with the Minimum Distance corresponding to the primary distance EUC DP from the First Minimum Value Searcher 503. The nearest neighboring distance value is determined and is being output as the Competing Distance corresponding to EUC_DC. The Second Minimum Value Searcher 504 also generates the Address addr_com_cdw of the Competing Codeword and forwards it to the Corrected Test Pattern Memory 516.

A Hard Decision Register 505 stores the demodulated data Y which corresponds to the sign information of the components of the received word r. A Test Pattern Register 506 stores test patterns based on input from an error Pattern generator 507 and from the Hard Decision Register 505. The Error Pattern Generator 507 generates 16 possible error patterns. A Channel Measurements Register 508 stores the channel measurements a which constitute the reliability information of the received sequence r. A Current Difference Metric Calculator 509 is connected to the First Minimum Value Searcher 503 and to the Second Minimum Value Searcher 504, and calculates the Current Difference DIFF_M as DIFF_M=EUC_DC-EUC_DP.

A Counter 510 is counted up with each Codeword Clock Pulse cdw_clk and provides its Counter Reading 521 to an Average Primary Distance Calculator 514 and an Average Competing Distance Calculator 515, where the reading serves to control the calculation of the Average Primary Distance dec mean and the Average Competing Distance com_ mean. 1024 distance values are accumulated during the first 1024 Codeword Clock Pulses cdw_clk, and the respective average value is computed after the 1024-th Codeword Clock Pulse cdw_clk.

A conventional BCH decoder 511, capable to decode and correct the BCH (63, 51, 5) code, receives Test Patterns 522 from the Test Pattern Register 506 and delivers Corrected Test Patterns 523. Erasure correction is not used. A Mapper 512 maps the Test Patterns 522 from the Test Pattern Register 506 into Bipolar Sequences 524. A Euclidean Distance Calculator 513 performs the calculation according to equation (1) above on its two inputs, namely the Bipolar Sequences 524 from the Mapper 512 and Channel Measurements 525 from the Channel Measurements Register 508, and outputs Euclidean Distance Values EUC_D to the Euclidean Distance Memory 517.

The Average Primary Distance Calculator 514 receives consecutive Minimum Distances EUC_DP and the Counter Reading 521, and calculates the Average Primary Distance dec_mean by the steps of: If the Counter Reading is <1024, the Minimum Distance EUC_DP is internally accumulated, else the accumulator content is divided by 1024 and output as Average Primary Distance dec_mean. The Average Competing Distance Calculator 515 performs correspondingly for the Average Competing Distance com_mean. The Corrected Test Pattern Memory 516 contains Corrected Test Patterns 523 received from the BCH Decoder 511. By using the Primary Codeword Address addr_pr_cdw or the Competing Codeword Address addr_com_cdw, it is equipped to output the corrected test patterns corresponding to the primary or competing codeword to a Multiplexer 520.

The Euclidean Distance Memory 517 holds 16 calculated Euclidean Distance Values EUC_D and provides them for the First Minimum Value Searcher 503 and the Second Minimum Value Searcher 504. An Average Difference Metric Calculator 518 calculates an Average Difference dif metric as the difference between the Average Primary Distance dec_mean and the Average Competing Distance com_mean. An Error Flag Generator 519 generates a Codeword Flag UE indicating the current codeword as either correctable (Codeword Flag = 0) or as uncorrectable (Codeword Flag = 1), depending on the Current Difference DIFF M and an Error Level parameter Error_I. It also uses a Primary Distance Not Found Information Euc_dp_not_found from the First Minimum Value Searcher 503 and a Competing Distance Not Found Information Euc_dc_not_found from the Second Minimum Value Searcher 504. The Error Level parameter Error_ I controls the probability of mis-corrected code word in Chase decoder. This parameter is controlled adaptively depending on the Average Difference dif_metric, as described below. The Multiplexer 520, controlled by the Codeword Flag UE, connects either a code word from the Hard Decision Register 505 or a code word from the Corrected Test Pattern Memory 516 to the Output Y of the Chase decoder modified according to this invention.

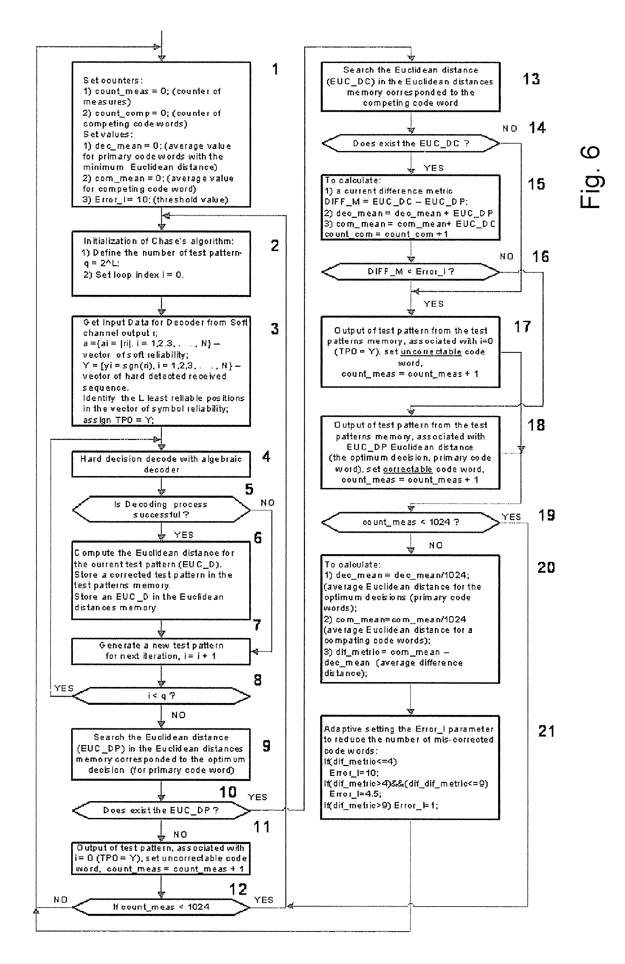

Fig. 6 shows a Flowchart of operations to be executed in the Chase decoder modified according to this invention.

In Step 1, initializations are performed:

- The Counter 510 is reset,
- A counter of competing codeword is reset,
- The accumulator of the Average Primary Distance Calculator 514 is reset,
- The accumulator of the Average Competing Distance Calculator 515 is reset, and
- The Error Level parameter Error_I is set to 10, a value which has been found experimentally during simulations.

In Step 2, the Chase decoder is initialized:

- The number of test patterns is set to $2^L=2^4=16$,
- An iteration loop counter i is set to zero.

In step 3, the Reliability Metric Generator 501 is fed from soft channel output r:

- The channel measurement or reliability vector a is determined,

where $a_i=|r_i|$ for i=1, ... , n.

- The Demodulated Data word Y is determined, where $Y_i=sgn(r_i)$ for i=1,...,n.
- The channel measurement a is analyzed and the locations of the L=4 least reliable symbols are determined and transferred to be stored in the Memory 502.
- The ai values are stored in the Channel Measurements Register 508 and the vector of hard detected bits $Y=y_i$ is stored in the Hard Decision Register 505.
- From the output of the Error Pattern Generator 507 and the output of the Hard Decision Register 505, a test pattern is created by mod2 addition and is stored in the Test Pattern Register 506.

In step 4, the BCH decoder 511 reads the current test pattern 522 from the Test Pattern Register 506 and tries to decode it. Step 5 tests if that decoding process is not successful. If so, the iteration counter i counts up, the Error Pattern Generator 507 together with the Hard decision register 505 creates a new test pattern 522 and processing continues at step 4.

In step 6, if decoding process is successful, the current test pattern TPi, 522 is mapped into a bipolar sequence in the mapper 512 and the mapped test pattern 524 is transferred to the Euclidean Distance Calculator 513. At the same time the soft information (ai) is being read from the Channel Measurements Register 508 and is also being transferred to the Euclidean Distance Calculator 513 in which the Euclidean Distance EUC_D is computed.

Then the EUC_D is loaded into the Euclidean distances memory 517 and the corrected test pattern 523 is loaded into the corrected test pattern memory 516.

Step 8 tests if 16 test patterns have been checked. If yes, then in step 9, the Chase decoder starts to search the EUC_D corresponding to the optimum decision EUC DP. For this, values are being read from the Euclidean Distance memory 517 and forwarded to the First Minimum Value Searcher 503 where the minimum value of these is determined.

Step 10 tests if EUC_DP has been found. If not, then in step 11, the First Minimum Value Searcher 503 generates an active euc_dp_not_found signal which is then forwarded to the Error Flag Generator 519. If this signal is active then the Error Flag Generator 519 generates an error flag UE=1. If UE=1, a hard detected code word from the Hard Decision Register 505 is output as the output Y of the Chase decoder. At the same time, the Counter 510 counts up.

In step 12, the counter reading 521 is compared to 1024. If the counter reading 512 is smaller than 1024, the Chase decoder starts to decode a new received sequence r; else the decoder starts to measure a new average difference distance dif_metric value.

If, in step 10, EUC_DP value does exist, then, in step 15, the EUC_DP value is transferred to the Average Primary Distance Calculator 514 for calculation of dec_mean value. The addr_pr_cdw address from the First Minimum Value Searcher 503, associated with optimum decision, is transferred to the Corrected Test Pattern Memory 516.

At the same time, in step 13, the Second Minimum Value Searcher 504 is initialized with the Euclidean distance associated with optimum decision (EUC_DP) from the First Minimum Value Searcher 503 and starts to search the Euclidean distance correspondent to the competing code word. Euclidean Distance values from Euclidean Distance Memory 517 are transferred and compared with minimum value. The nearest neighboring value is Euclidean distance EUC_DC for competing code word.

If, in step 14, EUC_DC value has not been found (does not exist), then the Second Minimum Value Searcher 504 generates the euc_dc_not_found signal which is forwarded to the Error Flag Generator 519. If this signal is active, then, in step 17, the Error Flag Generator 519 generates the error flag UE=1. In this case a corrected test pattern, from the Corrected Test Pattern Memory 516, associated with optimum decision, is output as the output Y of the Chase decoder. At the same time, the counter count_meas counts up.

Step 19 tests, whether the counter reading count_meas is less than 1024. If so, the Chase decoder branches to step 2, i.e. starts to decode a new received sequence r. If not, the decoder starts in step 20 to measure a new average difference distance value (dif_metric).

If, in step 14, an EUC_DC value has been found, then in step 15 the EUC_DC value is transferred to the Average Competing Distance Calculator 515 for calculation of the com_mean value.

The addr_com_cdw address from the Second Minimum Value Searcher 504, associated with competing code word, is transferred to the Corrected Test Pattern Memory 516. At the same time a current difference metric value DIFF_M is calculated in the Current Difference Metric Calculator 509 and is being forwarded for use in the Error flag Generator 519.

If, in step 16, DIFF_M<Error_1 is not true, then, in step 18, the Chase decoder outputs the test pattern associated with the optimum decision and sets error flag UE=0. Counter count_meas counts up.

If the test of step 16 is true, then, in step 17, the Chase decoder outputs the corrected test pattern associated with the hard detected sequence from the Hard Detect register 505 and sets error flag UE=1. Counter count_meas counts up.

The count_meas<1024 condition is checked during step 19. If condition 19 is true then Chase decoder starts to decode a new received sequence r; if the condition is false, then, in step 20, an average Euclidean distance for optimum decisions and an average Euclidean distance for competing code words are calculated, and afterwards an average difference distance is computed.

In step 21, the Error Flag Generator 519 adaptively sets the Error_1 parameter (probability of mis-corrected code word), depending on the dif_metric parameter. After step 21, the Chase decoder branches to step 1, i.e. starts to measure a new average difference distance value.

For flagging possibly miscorrected code words, the invention proposes a first flagging strategy fs1 and a second flagging strategy fs2. Within the first flagging strategy fs1, a first parameter setting set1 and a second parameter setting set 2 are distinguished.

In the first flagging strategy fs1, the Error_1 parameter defines the tolerance on the probability of mis-corrected code words in the Chase decoder. For this, the value range of the average difference distance dif_metric as shown in Fig. 2 is divided into three different regions:

a) A first region, where dif_metric is from 0 to 4, having a high probability of between 88% and 32% of mis-corrected codewords when Chase decoding is performed invariably, as shown by curve 301 of Fig. 3.

b) A second region, where dif_metric is from 4 to 9, having moderate percentage of mis-corrected code words between 32% and 0.1%.

c) A third region, where dif_metric is more than 9, having a low probability of mis-corrected code words less than 0.1%. According to these simulation results, the probability of mis-corrected code words is separately restricted for each region by either of two parameter settings set1, set2, in the Error Flag Generator 519.

In setting 1, if (dif_metric<=4) Error_1 is set to 6, if (dif_metric>4)&&(dif_metric<=9), Error_1 is set to 3, and if (dif_metric>9), Error_1 is set to 1.

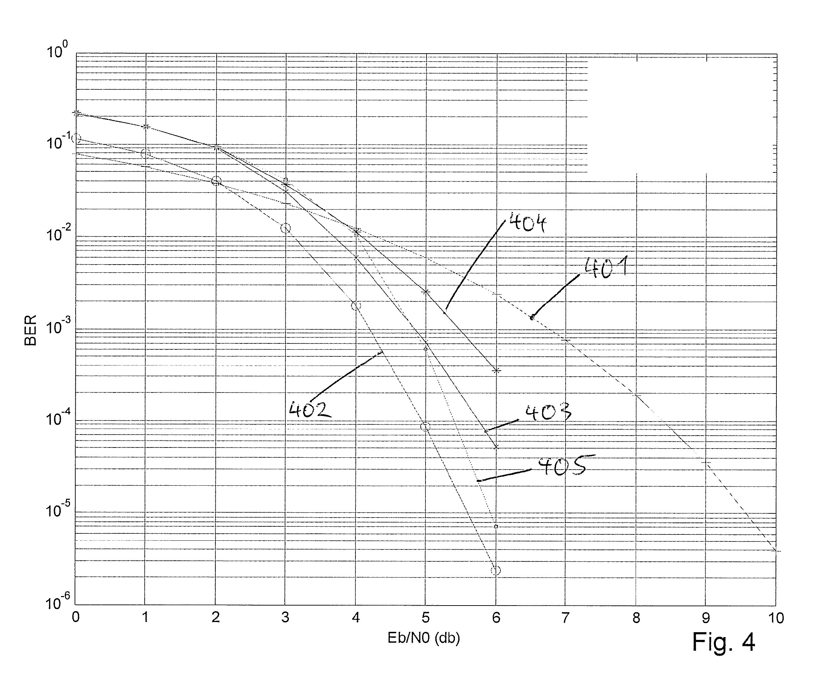

Fig. 4 shows bit error rates BER for known Chase decoders and for modified Chase decoders according to the invention, as a function of the signal to noise ratio Eb/N0. Curve 401 shows the bit error rate for the uncoded case. Curve 402 shows the bit error rate for the case of invariably performed Chase decoding, i.e. without reduction. Curve 403 shows the bit error rate for the case of Chase decoding with reduction according to the invention, using flagging strategy fs1 and setting set1. Curve 302 in Fig. 3 shows the corresponding percentage of mis-corrected code words for this case.

The probability of miscorrected codewords is further reduced with setting 2, where if (dif_metric<=4) Error_1 is set to 10, if (dif_metric>4)&&(dif_metric<=9), Error_1 is set to 5, and if (dif_metric>9), Error_1 is set to 1. Curve 404 in Fig. 4 shows the corresponding bit error rate for this case (fs1, set2), curve 303 in Fig. 3 shows the corresponding percentage of mis-corrected code words. Comparison of the curves in Fig. 3 shows the reduced percentage compared with setting 1.

In the second flagging strategy fs2, the Error_1 parameter is generated according to

$$Error\_1 = TV - dif\_metric,$$

where TV=10. Curve 405 in Fig. 4 shows the bit error rate BER of the Chase decoder with flagging strategy fs2. By increasing the TV value, the probability of mis-corrected codewords is further decreased.

Which of the flagging strategies, parameter settings and TV values to use, depends on the specific applications of the Chase decoder according to the invention. Also, Fig.3 and Fig.4 show that by reduction of the probability of miscorrection, the output BER of Chase decoder is increased. The best compromise between miscorrection reduction BER increase also depends on the specific application.

Advantages of the invention are as follows:

- Using a BCH Decoder instead of a Syndrome generator increases the error correction capability of the Chase decoder. A Chase decoder with L=4 ona BCH code (63, 51, 5) can correct some error patterns with up to 6 errors. A conventional Chase decoder can correct some error patterns with up to 4 errors.

- The reliability-based decoding in the Chase decoder requires generation of a list of candidate code words (test patterns) of a predetermined size to restrict the search space for finding the ML code word (optimal decision). These candidate code words are usually generated serially one at time. Each time a candidate code word is generated, its Euclidean distance is computed for comparison (Searcher of the minimum value in the Euclidean Distances Memory, block 3) and final decoding. If a condition can be derived to test - how many candidate code words are required for finding the optimum decision then decoding speed can be increased. The invention allows to estimate the input bit error rate (SNR) from the average difference metric dif_metric. We know that dif_metric has its minimum at 0 dB of SNR and increases monotonously in the area from 0 to 10 dB. At 0 dB, the bit error rate is highest, and at 10 dB it is lowest. hence dif_metric can be used to control the number of generated candidate code words (test patterns), which in turn increases the speed of Chase decoder. For example at a high SNR (dif_metric <=4), L=4 can be employed, so that the chase decoder investigates 16 test patterns; at a moderate SNR (4 < dif_metric <= 9), L=3 corresponding to the use of 8 test patterns can be used; and at low SNR (dif_metric>9), L=2 corresponding to 4 test patterns can be used.

- The Case decoder extended according to the invention allows to restrict the probability of mis-corrected code words during decoding. Guided by the average difference metric dif_metric, which depends on the input bit error rate, the correcting capability is deliberately limited, thus reducing the probability of mis-corrected code words.

In the invention, a decoder-side estimate of the channel error rate SNR is provided by calculating the difference between the average primary distance and the average competitor distance. looking at Fig. 1, one might think that the average primary distance, taken alone, could also serve to derive the SNR estimate. But the Euclidean distance is a nonlinear function and strongly depends on the input signal vector r:

$$(r-cm)^2 = r^2 - 2rcm + cm^2$$

Any attenuation of the input signal r, for instance, strongly influences the behavior of this function. The difference metric, however, is a linear function in r, which hence does not so strongly depend on the input signal (3):

$$(r-cm)^2 - (r-cn)^2 = 2r(cn-cm) + cm^2 - cn^2$$

Therefore, using a difference metric delivers less error during the SNR estimation than when using the primary Euclidean distance.

With other words, in the extended Chase decoder according to the invention, miscorrections are reduced by a method where for each received word r a binary multiplex control signal UE is derived, according to which either a hard demodulated word 526 or a Chase decoded codeword 527 is used as the output Y. Derivation of the multiplex control signal UE involves distances of the received word r to closest d and second closest s codewords, as well as averages dec_mean, com_mean and differences DIFF_M, dif_metric thereof.

**Claims**

1. A method for reducing miscorrection in an extended Chase decoder which receives a received symbol sequence comprising reliability information and groups it into received words (r), the method **characterized by** steps of

      - deriving, from the received words (r), an output multiplex control signal (UE) associated to each of output words (Y) of the extended Chase decoder and exhibiting one of a first and a second distinct value,
      - deriving, from each of the received words (r), a hard demodulated word (526) and a Chase decoded codeword (527),
      - using, as the output word (Y), the hard demodulated word (526) in case the associated output multiplex control signal (UE) exhibits the first distinct value,
      - using, as the output word (Y), the Chase decoded codeword (527) in case the associated output multiplex control signal (UE) exhibits the second distinct value.

2. The method of claim 1, where the step of deriving an output multiplex control signal (UE) comprises substeps of

      - determining, from each received word (r), a set of candidate codewords ($c_j$) by algebraic decoding of the received word (r) modified in all possible ways in its L least reliable symbol positions,
      - selecting, as a primary codeword (d), that codeword among the set of candidate codewords ($c_j$), that is closest to the received word (r),
      - selecting, as a competing codeword (s), that codeword among the set of candidate codewords ($c_j$), that is second closest to the received word (r),
      - calculating a primary distance (EUC_DP) and a competing distance (EUC_DC) between the received word (r) and the primary codeword (d) / competing codeword (s), respectively,
      - setting the output multiplex control signal (UE) to the first distinct value in case a distance difference (DIFF_M) between the competing distance (EUC_DC) and the primary distance (EUC_DP) is smaller than a threshold (Error_I), and to the second distinct value in case the distance difference (DIFF_M) is greater than or equal to the threshold (Error_I).

3. The method of claim 2, additionally comprising steps of:

      - calculating an average primary distance (dec_mean) and an average competing distance (com_mean) by temporally low pass filtering the sequences of primary distances (EUC_DP) and competing distances (EUC_DC), respectively,

- deriving the threshold (Error I) from the difference (dif_metric) between the average primary distance (dec_mean) and the average competing distance (com_mean).

4. The method of any of the previous claims, additionally comprising the steps of:

   - forwarding the output words (Y) and the associated output multiplex control signals (UE) to a subsequent stage of a descrambler or outer error correction decoder,
   - interpreting, in the subsequent stage, those of the output words (Y) as erasures, where the associated output multiplex control signal (UE) exhibits the first distinct value, and those of the output words (Y) as error free, where the associated output multiplex control signal (UE) exhibits the second distinct value.

5. An apparatus for reducing miscorrection in an extended Chase decoder, having a Reliability Metric Generator (501), a Current Difference Metric Calculator (509), an Average Primary Distance Calculator (514), an Average Competing Distance Calculator (515), a Euclidean Distance Calculator (513), a Multiplexer (520), and an Average Difference Metric Calculator (518), and
   **characterised by**
   being configured to perform a method according to one of claims 1 to 4.

Fig. 1

Fig. 2

Number of mis-corrected code words, %

Eb/N0 (db)

301

302

303

Fig. 3

Fig. 4

BER

Eb/N0 (db)

401
404
403
405
402

Fig. 5

EP 1 936 813 A1

**Fig. 6**

**1** — Set counters:
1) count_meas = 0; (counter of measures)
2) count_comp = 0; (counter of competing code words)
Set values:
1) dec_mean = 0; (average value for primary code words with the minimum Euclidean distance)
2) com_mean = 0; (average value for competing code word)
3) Error_I = 10; (threshold value)

**2** — Initialization of Chase's algorithm:
1) Define the number of test pattern- q = 2^L;
2) Set loop index I = 0.

**3** — Get Input Data for Decoder from Soft channel output r;
a = {ai = |ri|, i = 1,2,3, . . ., N} – vector of soft reliability;
Y = {yi = sgn(ri), i = 1,2,3, . . ., N} – vector of hard detected received sequence.
Identify the L least reliable positions in the vector of symbol reliability;
assign TP0 = Y;

**4** — Hard decision decode with algebraic decoder

**5** — Is Decoding process successful? — NO / YES

**6** — Compute the Euclidean distance for the current test pattern (EUC_D).
Store a corrected test pattern in the test patterns memory.
Store an EUC_D in the Euclidean distances memory.

**7** — Generate a new test pattern for next iteration, i = i + 1

**8** — i < q ? — YES / NO

**9** — Search the Euclidean distance (EUC_DP) in the Euclidean distances memory corresponded to the optimum decision (for primary code word)

**10** — Does exist the EUC_DP ? — YES / NO

**11** — Output of test pattern, associated with i = 0 (TP0 = Y), set uncorrectable code word, count_meas = count_meas + 1

**12** — If count_meas < 1024 — NO / YES

**13** — Search the Euclidean distance (EUC_DC) in the Euclidean distances memory corresponded to the competing code word

**14** — Does exist the EUC_DC ? — NO / YES

**15** — To calculate:
1) a current difference metric DIFF_M = EUC_DC – EUC_DP;
2) dec_mean = dec_mean + EUC_DP
3) com_mean = com_mean + EUC_DC
count_com = count_com + 1

**16** — DIFF_M < Error_I ? — NO / YES

**17** — Output of test pattern from the test patterns memory, associated with i=0 (TP0 = Y), set uncorrectable code word.
count_meas = count_meas + 1

**18** — Output of test pattern from the test patterns memory, associated with EUC_DP Euclidean distance (the optimum decision, primary code word), set correctable code word, count_meas = count_meas + 1

**19** — count_meas < 1024 ? — YES / NO

**20** — To calculate:
1) dec_mean = dec_mean/1024; (average Euclidean distance for the optimum decisions (primary code words);
2) com_mean = com_mean/1024 (average Euclidean distance for a compating code words);
3) dif_metric = com_mean – dec_mean (average difference distance);

**21** — Adaptive setting the Error_I parameter to reduce the number of mis-corrected code words:
If(dif_metric<=4) Error_I=10;
If(dif_metric>4)&&(dif_dif_metric<=9) Error_I=4.5;
If(dif_metric>9) Error_I=1;

**European Patent Office**

**EUROPEAN SEARCH REPORT**

Application Number

EP 06 12 6462

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHASE D: "A CLASS OF ALGORITHMS FOR DECODING BLOCK CODES WITH CHANNEL MEASUREMENT INFORMATION" IEEE TRANSACTIONS ON INFORMATION THEORY, IEEE SERVICE CENTER, PISCATAWAY, NJ, US, vol. 18, no. 1, January 1972 (1972-01), pages 170-182, XP000500203 ISSN: 0018-9448 ----- | 1-7 | INV. H03M13/45 |
| A | US 6 460 162 B1 (BUDA FABIEN [FR] ET AL) 1 October 2002 (2002-10-01) * the whole document * ----- | 1-5 | |
| A | FORNEY G D: "GENERALIZED MINIMUM DISTANCE DECODING" IEEE TRANSACTIONS ON INFORMATION THEORY, IEEE SERVICE CENTER, PISCATAWAY, NJ, US, vol. IT-12, April 1966 (1966-04), pages 125-131, XP001015807 ISSN: 0018-9448 * the whole document * ----- | 1-7 | |

TECHNICAL FIELDS SEARCHED (IPC)

H03M
H04M

The present search report has been drawn up for all claims

| Place of search | Date of completion of the search | Examiner |
|---|---|---|
| The Hague | 5 April 2007 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 12 6462

This annex lists the patent family members relating to the patent documents cited in the above-mentioned European search report.
The members are as contained in the European Patent Office EDP file on
The European Patent Office is in no way liable for these particulars which are merely given for the purpose of information.

05-04-2007

| Patent document cited in search report | | Publication date | Patent family member(s) | | Publication date |
|---|---|---|---|---|---|
| US 6460162 | B1 | 01-10-2002 | AU | 3525699 A | 23-11-1999 |
| | | | BR | 9906417 A | 11-07-2000 |
| | | | CN | 1266555 A | 13-09-2000 |
| | | | EP | 0995272 A1 | 26-04-2000 |
| | | | FR | 2778289 A1 | 05-11-1999 |
| | | | WO | 9957816 A1 | 11-11-1999 |
| | | | ID | 25644 A | 19-10-2000 |
| | | | JP | 2002509680 T | 26-03-2002 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5559506 A
- US 6134694 A
- US 6065147 A
- US 20040247238 A
- US 5010554 A

### Non-patent literature cited in the description

- **G. C. CLARK, JR ; J. B. CAIN.** Error-Correction Coding For Digital Communications. Plenum Press, 176-172